# EUROPÄISCHE PATENTSCHRIFT

(11) **EP 0 727 508 B1**
(45) Veröffentlichungstag und Bekanntmachung des Hinweises auf die Patenterteilung: **09.06.1999**
(21) Anmeldenummer: 96102259.7
(22) Anmeldetag: 15.02.1996
(51) Int. Cl.: C23C 16/44, C23C 16/50

(54) **Verfahren und Vorrichtung zur Behandlung von Substratoberflächen**
Method and apparatus for treatment of substrate surfaces
Procédé et appareil de traitement de surfaces de substrats

(30) Priorität: 16.02.1995 DE 19505268
(43) Veröffentlichungstag der Anmeldung: 21.08.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Jung, Thomas, Dr. rer. nat., 38110 Braunschweig (DE)
(74) Vertreter: Pfenning, Meinig & Partner

(56) Entgegenhaltungen:
- DE-A- 3 620 214
- PATENT ABSTRACTS OF JAPAN vol. 012, no. 022 (C-470), 22.Januar 1988 & JP-A-62 174382 (SHINDENGEN ELECTRIC MFG CO LTD;OTHERS: 01), 31.Juli 1987,
- PATENT ABSTRACTS OF JAPAN vol. 012, no. 146 (E-605), 6.Mai 1988 & JP-A-62 262419 (FUJI ELECTRIC CO LTD), 14.November 1987,
- PATENT ABSTRACTS OF JAPAN vol. 004, no. 152 (E-031), 24.Oktober 1980 & JP-A-55 102237 (HITACHI LTD), 5.August 1980,
- Thin Solid Films, 219 (1992), Nr. 1/2, 30.Oktober 1992, Lausanne CH, Seiten 4-6

## Beschreibung

Die Erfindung betrifft ein Verfahren und eine Vorrichtung zur Behandlung von Substratoberflächen, insbesondere der Beschichtung, dem Abtrag von Schichten oder von Teilen der Oberfläche und der Aktivierung für eine nachfolgende Beschichtung zur Verbesserung der Haftung, wie sie beispielsweise bei empfindlichem Substratmaterial erforderlich ist.

Es ist bekannt, plasmagestützte CVD-, Abtrags- und Aktivierungs-Prozesse mit einer Gleichspannung bzw. niederfrequenter Wechselspannung unter Verwendung herkömmlicher Elektroden durchzuführen. Hierbei wirkt es sich nachteilig aus, daß der Prozeß durch Oberflächenveränderungen an den Elektroden (Schichtbildung) instabil wird und hohe Spannungen erforderlich sind, die unerwünscht hohe Ionenenergien zur Folge haben.

CVD-, Abtrags- und Aktivierungs-Prozesse werden auch bereits mittels Hochfrequenz in kapazitiv gekoppelten Parallelplattenreaktoren oder in kapazitiv bzw. induktiv gekoppelten Rohrreaktoren angeregt (S. Veprek, Thin Solid Films 130 (1985), S. 135 und D. Bollinger u.a., Solid State Technology, Mai 1985, S. 111). Mit dieser Vorgehensweise sind jedoch nur eine geringe Plasmadichte und aus diesem Grund nur eine geringe Abscheiderate erreichbar. Die Hochfrequenz Anregung ist aufwendig. Außerdem ist es nachteilig, daß das Substrat durch die hohen Teilchenenergien thermisch hoch belastet wird und so nicht alle Materialien behandelt werden können. Es bestehen Grenzen bei Beschichtung und Abtrag größerer Flächen durch die Eingangsimpedanz der HF-Entkopplungsglieder bedingt.

Aus J. Asmussen, J. Vac. Sci. Technol. A7 (1989), S. 883 und T. Ono u.a., J. Vac. Sci. Technol. B4 (1986), S. 696, ist die Anregung von CVD-, Abtrags- und Aktivierungs-Prozessen mit Mikrowellen in einem ECR-Reaktor bekannt. Die Mikrowellenanregung ist ebenfalls technisch aufwendig. Für die Behandlung größerer Flächen ist eine Batterie bestehend aus mehreren vollständigen Einzel-ECR-Quellen (inkl. Generator, Abstimmung, Antenne, Magnetspule, Magnetversorgung) erforderlich. Probleme ergeben sich dabei eine gleichmäßige Abstimmung der Quellen zu erreichen.

P. J. Kung, Y. Tzeng, J. Appl. Phys. 66 (1989), S. 4676 und J. Stiegler u.a., Thin Solid Films 219 (1992), S. 4, ist die Anregung solcher Prozesse mit einer Hohlkathoden-Bogenentladung zu entnehmen. Mit dieser vorbekannten Verfahrensweise können ebenfalls nur kleine Flächen behandelt werden, da die Anregungsquelle sehr klein ist (0,5 bis 5 mm). Die verwendete Hohlkathode muß erst vorgeheizt werden, und ein schnelles Anfahren ist daher nicht möglich.

Eine Möglichkeit zur Beschichtung von Substraten mit einer Metallegierung ist in JP-A-62 174 382 beschrieben. Dort soll ein Plasma in einer Vakuumkammer mittels Hohlkathodenglimmentladung erzeugt und ein separates Reaktivgas zugeführt werden. Zur Erzeugung des Plasma wird H₂ durch die Hohlkathode geführt, der mit fast allen leitfähigen Materialien, wie sie auch für Hohlkathoden verwendet werden, Hydride bildet.

Ausgehend hiervon, ist es Aufgabe der Erfindung, Möglichkeiten zu schaffen, um die Anregung von Beschichtungs-, Abtrags- und Aktivierungs-Prozessen im Vakuum auf einfache Weise, bei gleichzeitig höherer Variabilität, insbesondere auch die Möglichkeit der Behandlung größerer Oberflächenbereiche zu erreichen.

Erfindungsgemäß wird diese Aufgabe unter Verwendung der Merkmale des Anspruchs 1 für das Verfahren und der Merkmale der Ansprüche 18 bis 20 für entsprechende Vorrichtungen gelöst. Die Unteransprüche zeigen vcrteilhafte Weiterbildungen auf.

Mit der Erzeugung von Inertgas-Plasma unter Verwendung einer Hohlkathoden-Glimmentladung in Verbindung mit der Trennung von Behandlungszone und der durch die Hohlkathode vorgegebenen Entladungszone mittels des Inertgasstromes und der Zugabe von Reaktivgas, so daß eine Reaktion mit dem Elektrodenmaterial weitgehend vermieden wird, ist eine sichere über einen langen Zeitraum kontinuierliche Prozeßführung möglich. Instabilitäten bei der Entladung werden vermieden. Die Behandlung der Substratoberfläche zum Beschichten, Abtragen oder Aktivieren kann gezielt durchgeführt werden und die Beeinträchtigung des Substrates ist durch eine geringe thermische Belastung, infolge energiearmen Teilchenbeschusses nicht zu befürchten, so daß auch empfindliche Materialien ohne weiteres behandelt werden können. Schicht- oder Substratdefekte können vermieden werden, obwohl impulsreiche Teilchen (Ionen, neutrale Teilchen) aus dem Plasma auf das Substrat beschleunigt werden.

Der wesentliche Unterschied zum bekannten Hohlkathoden-Sputtern besteht somit darin, daß der beim Hohlkathoden-Sputtern verfahrensbestimmende Materialabtrag von der Kathode und der nachfolgende Transport zum Substrat weitgehend vermieden bzw. zurückgedrängt wird. Ein Eintrag von Elektrodenmaterial in die Schicht mit nachteiliger Wirkung auf die Schichteigenschaften wird somit beim erfindungsgemäßen Verfahren durch geeignete Gestaltung der Elektroden, der Gasführung und/oder der Betriebsparameter zurückgedrängt bzw. vollständig unterdrückt. Das Verfahren beruht somit auf einem dem CVD-Prinzip bzw. dem plasmachemischen Reinigen oder Ätzen oder Aktivieren vergleichbaren Prinzip und nicht auf dem PVD-Prinzip.

Um die vorstehend beschriebenen Effekte zu erreichen, ist es vorteilhaft, wenn der Arbeitsdruck, der beim Sputtern im Bereich von 0,3 bis 0,8 mbar liegt, auf mehr als 0,8 mbar, bevorzugt auf 0,8 - 10 mbar bei Beibehaltung eines konstanten Gasflusses erhöht wird. Ein vorteilhafter Gasfluß liegt, je nach Baugröße im Bereich von 0,001 bis 10 slm (Standardliter pro Minute), bevorzugt im Bereich von 0,1 bis 2 slm. Dadurch verringert sich bei konstanter Leistung die Entladungsspanung von 500 bis 800 V auf 100 bis 500 V und der Sputterabtrag wird somit ineffizienter, außerdem vermindert sich die Transportleistung des Gasstroms durch dessen geringe Geschwindigkeit. Unterstützend ist es weiterhin bevorzugt, wenn die Kathodenweite, d.h. der Abstand der gegenüberliegenden Elektroden von 2 bis 8 cm auf 0,2 bis 1 cm verringert wird. Gleichzeitig kann die Kathodentiefe von 4 bis 10 cm auf 0,5 bis 2 cm verringert werden, sodaß sie wieder das etwa 1- bis 2-fache der Kathodenweite erreicht.

Wesentlich für das erfindungsgemäße Verfahren ist weiterhin, wie bereits vorstehend erläutert, die Führung des Inertgasstroms, d.h. die Erzeugung des Inertgas-Plasmas und deren Transport zum Substrat. Vorteilhafterweise wird dabei so vorgegangen, daß die Strömungsgeschwindigkeit des Inertgas-Plasmas beim Verlassen der Hohlhathode erhalten oder erhöht wird. Verfahrenstechnisch kann dies z.B. dadurch realisiert werden, daß zur Unterdrückung der Reaktion von Reaktivgas mit dem Kathodenmaterial zusätzlich oder ausschließlich am substratseitigen Ende Inertgas eingespeist und in Richtung auf das Substrat geführt wird.

Eine weitere Maßnahme kann darin bestehen, Elektroden einzusetzen, die aus einem Material bestehen, das nur eine sehr geringe Sputterausbeute aufweist. Beispiele hierfür sind hochschmelzende Oxide. Die zur Aufrechterhaltung der Entladung erforderliche elektrische Leitfähigkeit wird durch die Materialwahl, die Anregungsfrequenz (Verschiebungsstrom), die Materialstärke oder die Materialtemperatur gewährleistet.

Zur weiteren Reduzierung des Sputterabtrages von den Elektroden ist es auch möglich, ein zusätzliches Gas in die Hohlkathode einzuführen, wodurch der Sputterabtrag verringert wird. In Versuchen hat es sich gezeigt, daß eine geringe Konzentration von Wasserstoff in der Hohlkathode bei manchen Metallen (Aluminium, Titan) eine starke Verringerung des Sputterabtrags von der Kathodenoberfläche bewirkt.

Für die Plasmaerzeugung ist lediglich ein Netztransformator bzw. ein Gleichrichter erforderlich. Negative Einflüsse, wie sie bei höheren Frequenzen auftreten, werden vermieden. Der Wirkungsgrad ist gegenüber den bekannten Lösungen höher.

Mit der erfindungsgemäßen Verfahrensweise sind durch hohe Plasmadichte hohe Abscheide- bzw. Abtragsraten möglich.

Mit dem Anlegen einer Vorspannung an das Substrat kann die Stromdichte des Ionenstroms erhöht werden, um das Schichtwachstum oder die Abtragsgeschwindigkeit zu erhöhen. Bevorzugt wird eine negative Spannung im Bereich von 10 bis 800 V, besonders bevorzugt von 20 bis 500 V, angelegt. Dabei ist die Ionenenergie relativ gering. Ionenenergien von wenigen 10 eV übersteigen die chemische Bindungsenergie, bewirken aber nur einen so geringen Energieeintrag, der keinen negativen Einfluß auf das Substrat hat.

Mit dem Anlegen einer negativen Spannung an das Substrat von einigen 100 V und der Verwendung von Argon als Inertgas und Ethin als Reaktivgas, kann eine amorphe, diamantähnliche Kohlenstoff-Schicht erzeugt werden.

Weitere mögliche Reaktivgase sind Si-Verbindungen, Kohlenwasserstoffe, H₂, O₂, N₂ oder halogenhaltige Gase.

Die Einstellung der Ionenenergie kann je nach Bedarf in bezug auf Schichtwachstum und Abtragungsgeschwindigkeit auf einfache Weise erfolgen. So können mittlere Ionenenergien eingestellt werden, wenn die zu bildende Schicht dies erfordert oder der Abtrag auf physikalischem Weg (Zerstäubung) erfolgen soll. Mit der verwendeten, einfacher als die herkömmlichen Quellen (Dioden-Zerstäuber) aufgebauten Hohlkathode kann stabiler gearbeitet werden, da das Substrat nicht als Kathode geschaltet ist.

Vorteilhaft beim erfindungsgemäßen Verfahren ist, daß verschiedene Möglichkeiten vorhanden sind, um Einfluß auf die Prozeßführung zu nehmen. Dabei sind, wie vorstehend erläutert, die Plasmaintensität, der Transport des Plasma und der Ionenbeschuß des Substrates über die Entladungsspannung bzw. Leistung, die Gasströmung und die an das Substrat angelegte Spannung jeweils einzeln oder in Kombination steuer- bzw. regelbar.

Durch die gezielte Führung der Inertgasströmung können somit infolge des so hervorgerufenen Verdrängungseffektes geringere Anforderungen an den Restgaspegel in der Vakuumkammer gestellt werden als bei den bekannten Verfahren. Der Druck in der Vakuumkammer sollte im Bereich zwischen 0,1 mbar und 10 mbar gehalten werden.

In vorteilhafter Weise wird die Strömungsgeschwindigkeit des Inertgasstromes am zum Substrat weisenden Teil beim Verlassen der Hohlkathode erhöht und so die Entladungszone noch besser abgeschirmt. Damit wird insbesondere das Eindiffundieren von Reaktivgas in die Hohlkathode wirksam unterdrückt und ein negativer Einfluß, der durch Reaktion des Reaktivgases mit dem Elektrodenmaterial an deren Oberfläche auftreten könnte, verhindert. Die Geschwindigkeitserhöhung kann durch einfache Drosselung des Inertgasstromes in diesem Bereich herbeigeführt werden, wobei die Drosselstelle ebenfalls abschirmend wirkt.

Mit der erfindungsgemäßen Lösung können die verschiedensten Substrate behandelt werden. Dabei kann eine Anpassung an verschiedene, auch größere Oberflächenbereiche und auch an verschiedene Formen vorgenommen werden, so daß ein universellerer Einsatz möglich ist.

Für die Erzeugung der Glimmentladung mit der Hohlkathode kann an diese bevorzugt eine Gleichspannung auch in gepulster Form angelegt werden.

Es besteht aber auch die Möglichkeit, mit Wechselspannungen verschiedener Frequenzen (niederfrequent bis 1kHz, mittelfrequent von 1 bis 100 kHz oder auch mit Hochfrequenz) zu arbeiten. Es können aber auch Hochspannung oder mindestens ein Magnetfeld verwendet werden.

Nachfolgend soll die Erfindung an Ausführungsbeispielen näher erläutert werden. Dabei zeigen:
- Fig. 1: eine erfindungsgemäße Vorrichtung mit einer rohrförmigen Hohlkathode;
- Fig. 2: ein zweites Ausführungsbeispiel mit einer trichterförmigen Hohlkathode;

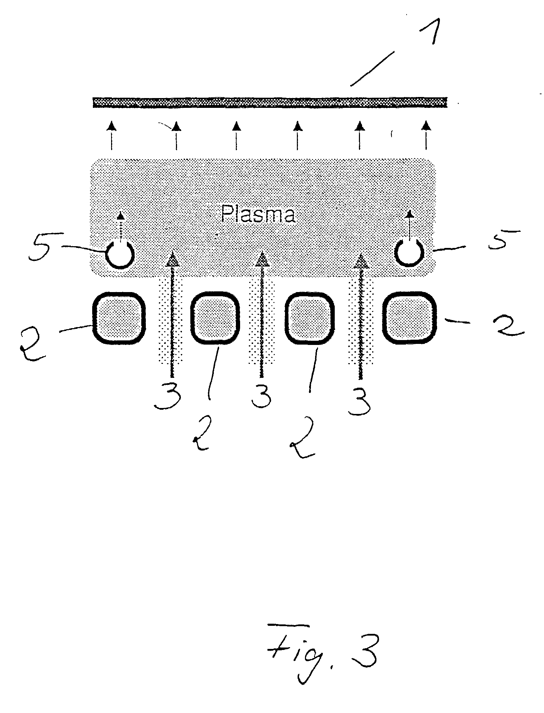

- Fig. 3: ein drittes Ausführungsbeispiel mit mehreren Hohlkathoden;
- Fig. 4: ein viertes Ausführungsbeispiel zur gleichzeitigen Behandlung mehrerer Substrate und zentraler Inertgaszuführung;
- Fig. 5: ein fünftes Ausführungsbeispiel mit einer netzförmigen Kathode;
- Fig. 6: ein sechstes Ausführungsbeispiel mit mehreren parallel angeordneten stab - oder rohrförmigen Kathodenelementen;
- Fig. 7: eine erfindungsgemäße Vorrichtung nach Fig. 1, jedoch mit Drosselstelle; und
- Fig. 8: ein weiteres Ausführungsbeispiel, bei dem die Kathode von einem Gehäuse umschlossen ist.

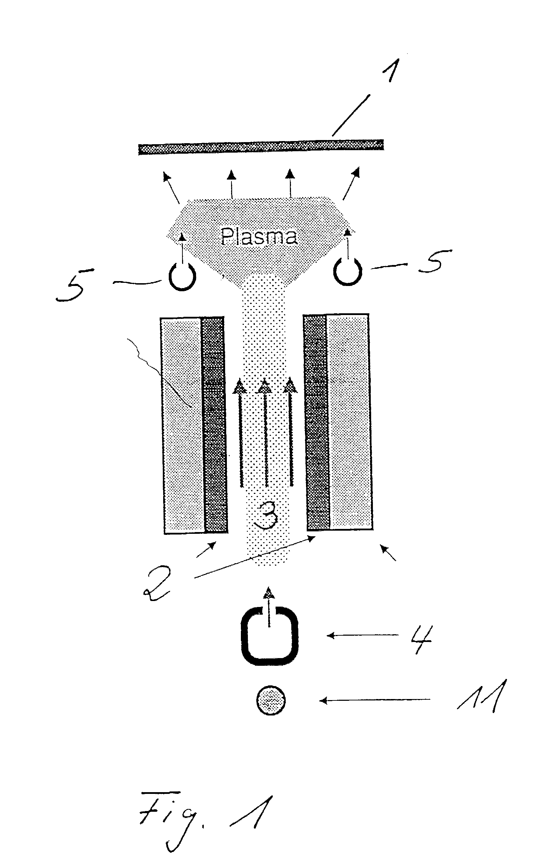

Das in der Figur 1 dargestellte Beispiel einer erfindungsgemäßen Vorrichtung zeigt ein in einer nicht dargestellten Vakuumkammer angeordnetes Substrat 1 und eine Hohlkathode 2, durch die ein mittels einer Inertgaszuführung 4 transportiertes Inertgas 3 in Richtung auf das Substrat 1 geblasen wird. Ein wesentlicher Teil des durch die Hohlkathoden-Glimmentladung erzeugten Plasma wird im Bereich zwischen dem substratseitigen Ende der Hohlkathode 2 und dem Substrat 1 gehalten. Das Plasma dient zur Anregung einer chemischen Dampfabscheidung in Verbindung mit über Reaktivgasdüsen 5, die außerhalb der Hohlkathode 2 angeordnet sind, zugeführtem Reaktivgas. Hierbei kann je nach gewünschter Beeinflussung des Substrates mit einem oder auch mehreren verschiedenen Raktivgasen gearbeitet werden. Die Hohlkathode 2 kann auch bei diesem Beispiel gekühlt werden. Vorteilhaft ist auch die gesonderte Anordnung der Anode 11 außerhalb des Beschichtungsbereiches, so daß auch diese nicht negativ beeinflußt wird. Die Ausbildung der Hohlkathode 2 kann hierbei rohrförmig und zur Beschichtung großer Substrate 1 auch in Form von nahezu parallel angeordneten Platten mit entsprechend großer Länge gewählt werden.

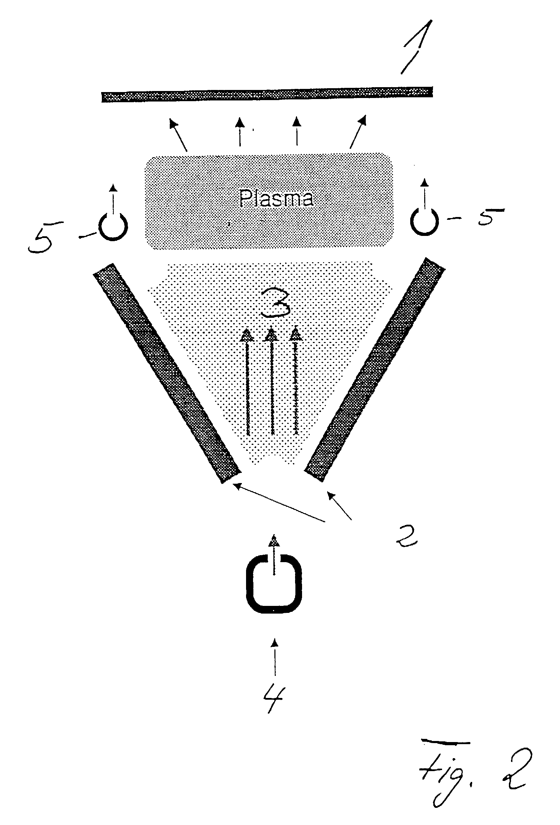

Das in der Figur 2 gezeigte Ausführungsbeispiel entspricht im wesentlichen dem vorangestellten Beispiel. Es ist lediglich die Hohlkatode 2 anders ausgebildet. Hierbei ist eine Trichterform gewählt worden, deren größere Öffnung auf das Substrat 1 gerichtet ist. Der Trichter kann aus einem kegelstumpfförmigen Mantel bestehen, aber auch pyramidenstumpfförmig ausgebildet sein. Die Wahl einer solchen Hohlkathode 2 ist für größere Substratoberflächen günstig.

Bei dem dritten Ausführungsbeispiel wird die Hohlkathode 2 aus mehreren rohrförmigen Einzelelementen gebildet. Diese können bevorzugt parallel zueinander angeordnet sein und so durch ihre relativ große Größe die Möglichkeit einer Behandlung größerer Substratoberflächen eröffnen. Das Inertgas 3 wird durch die Zwischenräume der Einzelelemente der Hohlkathode 2 auf das Substrat 1 gerichtet. Die Hohlräume der Einzelelemente können zur Kühlung aber auch zur Zuführung von Gas genutzt werden. Bei diesem Beispiel ist die Form der Rohre rechteckig mit abgerundeten Kanten, es können aber auch andere Formen, wie z.B. runde verwendet werden. Die Wahl der Form der Hohlkathode 2 kann auch beim Ausführungsbeispiel nach Figur 1 variiert sein.

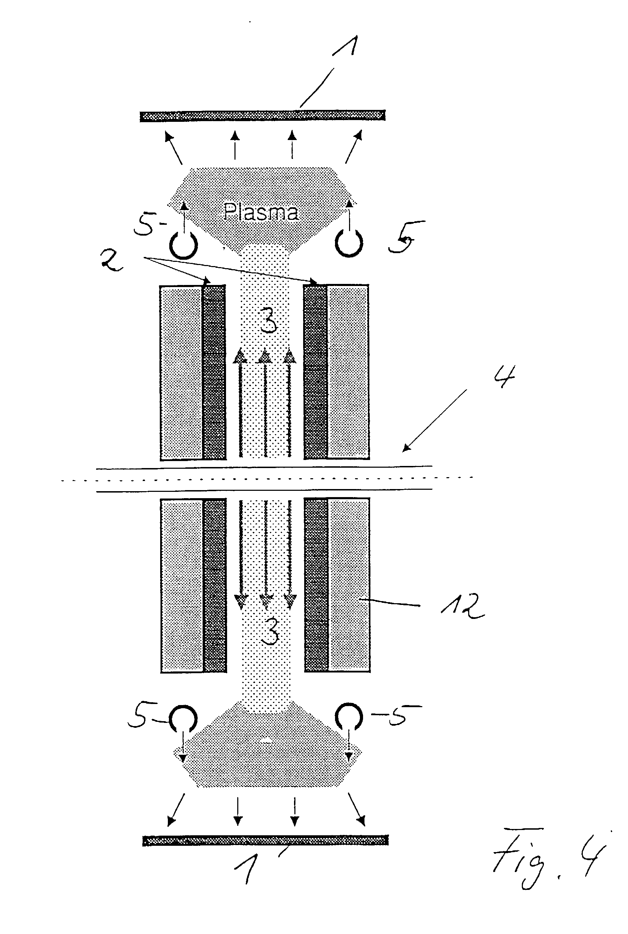

Das in der Figur 4 dargestellte Beispiel entspricht im wesentlichen dem des ersten beschriebenen Beispiels, es kann aber auch bei der zweiten Ausführungsform verwendet werden. Hierbei sind im Gegensatz zu den bereits genannten Beispielen mehrere Hohlkathoden 2 vorhanden und es wird eine zentrale Inertgaszuführung 4 verwendet. Ein solche Vorrichtung eignet sich besonders bei der Behandlung von Hohlräumen. Die Hohlkathoden 2 sind bei diesem Beispiel entweder durch die zentrale Inertgaszuführung 4 und/oder mittels einer Scheibe bzw. Platte voneinander getrennt.

Schließlich können die Kathoden hier auch die Form kreisringförmiger Scheiben haben, wobei zwei oder mehr Kathoden parallel und koaxial angeordnet sind und das Intergas radial aus einem zentralen Düsenrohr austritt.

Hier ist auch eine Kühlung 12 dargestellt, wie sie auch bei den anderen Beispielen vorhanden sein kann.

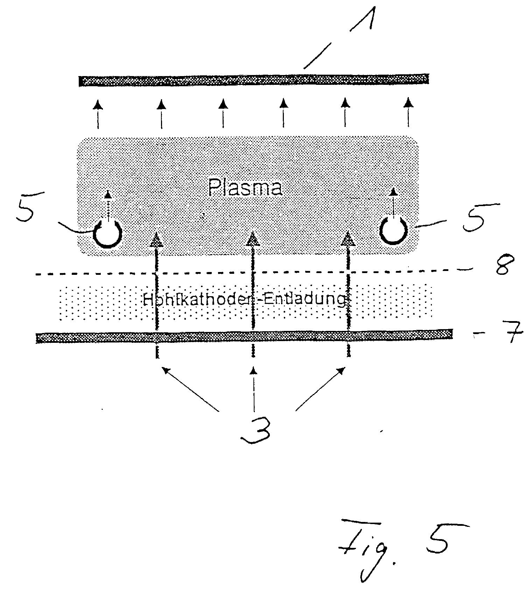

Bei dem fünften Beispiel (Fig. 5) wird die Hohlkathode aus zwei Teilen, einer Platte 7 und einem Netz 8 gebildet. Das Inertgas 3 strömt dabei durch die Maschen des Netzes 8 in Richtung auf das Substrat 1 und bewirkt so die Trennung der Entladungszone von der Behandlungszone. Die Reaktivgasdüsen 5 sind wie bei den anderen Beispielen außerhalb der Hohlkathode angeordnet.

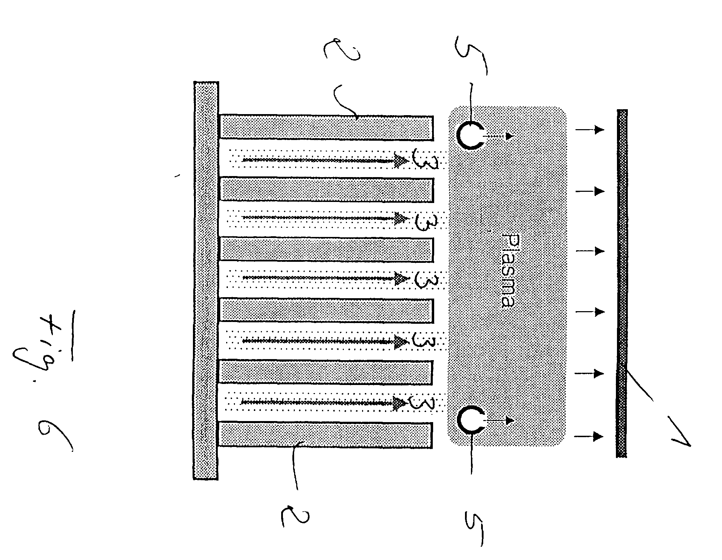

Die Hohlkathode 2 des in der Figur 6 gezeigten Beispiels besteht wieder, wie beim dritten Beispiel, aus mehreren Einzelelementen, die zwar ebenfalls parallel zueinander angeordnet sind, jedoch orthogonal zum Substrat 1 ausgerichtet sind. Das Inertgas 3 wird wieder durch die Zwischenräume auf das Substrat 1 gerichtet. Auch können die Innenräume der Einzelelemente zur Kühlung oder Gaszuführung benutzt werden. Eine Kühlung kann sich bei allen vorgeschlagenen Hohlkathoden 2 vorteilhaft auswirken.

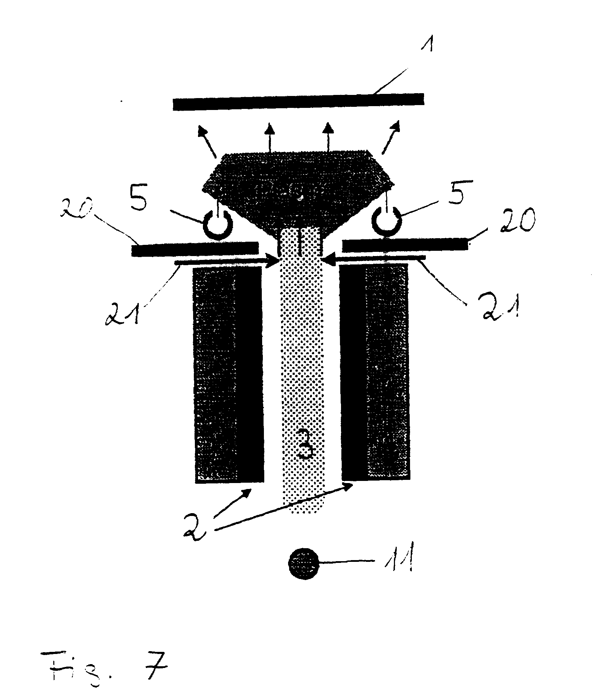

Figur 7 zeigt nun eine erfindungsgemäße Ausführungsform einer Vorrichtung zur Durchführung des Verfahrens, wie sie bereits in Fig. 1 beschrieben wurde, jedoch zusätzlich mit einer substratseitigen Drosselstelle. Diese bevorzugte Ausführungsform weist zwei Drosselstellen 20 auf, die den offenen Querschnitt der substratseitigen Öffnung verringern, so daß eine Strömungserhöhung des Inertgasstromes von der Hohlkathode zum Substrat eintritt. Durch diese Maßnahme wird erreicht, daß die im Zwischenraum zwischen der Drosselstelle 20 und dem Substrat 1 zugeführten Reaktivgase über die Reaktivgasdüsen 5 nicht in den Hohlraum der Hohlkathode eindiffundieren können. Ergänzend ist bei dieser Ausführungsform noch vorgesehen, zusätzlich Inertgas, z.B. Argon, unter den Drosselstellen 20 über Zuführungen 21 zuzuleiten. Dadurch werden die im Inertgas-Plasma 3 vorhandenen Inertgas-Ionen, z.B. die Argon-Ionen, durch das so zugeführte Argon mitgenommen und dem Reaktivgas zugeführt, so daß hier eine Aktivierung der Reaktivgase mit den Inertgas-Ionen erfolgen kann. Vor allem aber wird der Transport von eventuell abgestäubtem Kathodenmaterial zum Substrat stark herabgesetzt.

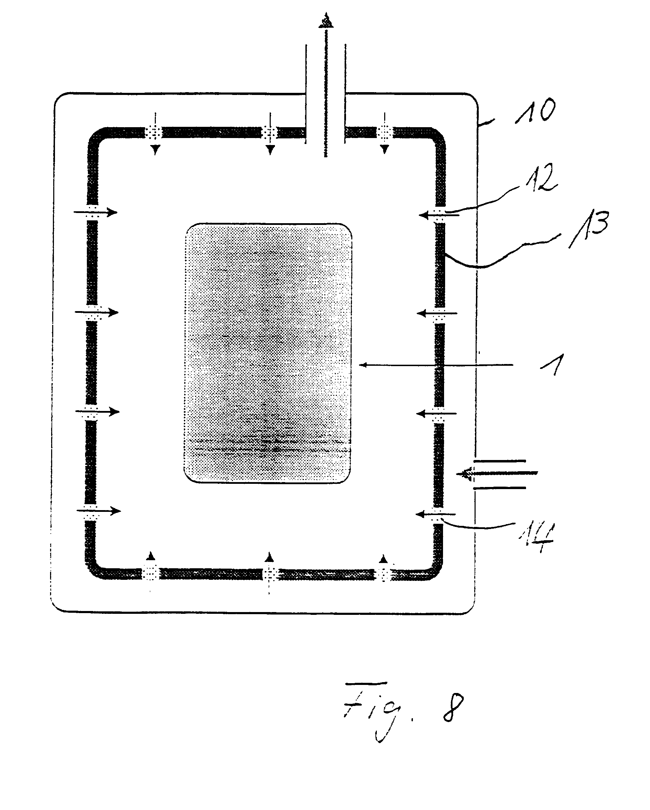

Das achte Beispiel (Figur 8) unterscheidet sich von allen bereits beschriebenen Beispielen durch die Verwendung eines Gehäuses 10, das die Kathode 12 und das Substrat 1 umschließt. Das Gehäuse 10 verfügt über Zuführ- und Abführöffnungen für Gas, die entsprechend durch Pfeile gekennzeichnet sind. Das Substrat 1 ist von einem weiteren Gehäuse 13 umgeben, in dem die die Hohlkathode bildenden Durchbrechungen 14 eingebracht sind. Die in diesem Beispiel gezeigte Ausführungsform ermöglicht eine großflächige Behandlung. Durch die die Hohlkathode bildenden Durchbrechungen 14 strömt das Inertgas in Richtung auf das Substrat 1; dadurch können Reaktionen mit der Hohlkathoden-Oberfläche weitgehend vermieden werden.

## Patentansprüche

1. Verfahren zur Behandlung von Substratoberflächen mit einer Hohlkathode, bei dem ein Plasma mit einer Hohlkathoden-Glimmentladung im Vakuum erzeugt und in Richtung auf das Substrat geführt,ein Reaktivgasstrom durch Strömung oder Diffusion in das zwischen dem substratseitigen Ende der Hohlkathode und dem Substrat vorhandene Plasma geleitet wird,
dadurch gekennzeichnet,
daß das Plasma mit einem durch die Hohlkathode geführten inerten Gas erzeugt und durch separate Steuerung der Inertgas-Plasma-Intensität, des Transportes und des Ionenbeschusses des Substrates mittels der Entladungsleistung, der Gasströmung und/oder einer an das Substrat angelegten Spannung, diese so eingestellt werden, daß eine Reaktion von Reaktivgas und Kathodenmaterial weitestgehend unterbunden wird.

2. Verfahren nach Anspruch 1,
dadurch gekennzeichnet, daß mit einem Arbeitsdruck 0,1 bis 10 mbar und einem Gasfluß von 0,001 bis 10 slm (Standardliter pro Minute) gearbeitet wird.

3. Verfahren nach Anspruch 1 oder 2,
dadurch gekennzeichnet, daß mit einer Entladungsspannung von 100 bis 500 V gearbeitet wird.

4. Verfahren nach mindestens einem der Ansprüche 1 bis 3,
dadurch gekennzeichnet, daß eine Spannung an das Substrat von 10 bis 800 V angelegt wird.

5. Verfahren nach mindestens einem der Ansprüche 1 bis 4,
dadurch gekennzeichnet, daß die Strömungsgeschwindigkeit des Inertgas-Plasmas beim Verlassen der Hohlkathode erhalten oder erhöht wird.

6. Verfahren nach mindestens einem der Ansprüche 1 bis 5,
dadurch gekennzeichnet, daß zur Unterdrückung der Reaktion von Reaktivgas mit dem Kathodenmaterial zusätzlich oder ausschließlich am substratseitigen Ende Inertgas eingespeist und in Richtung auf das Substrat geführt wird.

7. Verfahren nach mindestens einem der Ansprüche 1 bis 6,
dadurch gekennzeichnet, daß die Hohlkathoden-Glimmentladung mit Gleichspannung erzeugt wird.

8. Verfahren nach mindestens einem der Ansprüche 1 bis 7,
dadurch gekennzeichnet, daß die Hohlkathoden-Glimmentladung mit gepulster Gleichspannung erzeugt wird.

9. Verfahren nach mindestens einem der Ansprüche 1 bis 6,
dadurch gekennzeichnet, daß die Hohlkathoden-Glimmentladung mit einer Wechselspannung erzeugt wird.

10. Verfahren nach mindestens einem der Ansprüche 1 bis 6,
dadurch gekennzeichnet, daß die Hohlkathoden-Glimmentladung mit einer Hochspannung erzeugt wird.

11. Verfahren nach mindestens einem der Ansprüche 1 bis 10,
dadurch gekennzeichnet, daß durch ein Magnetfeld die Ausbreitung des Plasmas zum Substrat verstärkt wird.

12. Verfahren nach mindestens einem der Ansprüche 1 bis 11,
dadurch gekennzeichnet, daß die Hohlkathode gekühlt wird.

13. Verfahren nach mindestens einem der Ansprüche 1 bis 12,
dadurch gekennzeichnet, daß als Inertgas Argon verwendet wird.

14. Verfahren nach mindestens einem der Ansprüche 1 bis 13,
dadurch gekennzeichnet, daß als Reaktivgas Siliziumverbindungen, Kohlenwasserstoffe, z.B. Ethin, H₂, O₂, N₂ oder halogenhaltige Gase verwendet werden.

15. Verfahren nach einem der Ansprüche 1 bis 14,
dadurch gekennzeichnet, daß eine Schicht auf dem Substrat abgeschieden wird.

16. Verfahren nach einem der Ansprüche 1 bis 15,
dadurch gekennzeichnet, daß Substratmaterial abgetragen wird.

17. Verfahren nach einem der Ansprüche 1 bis 16,
dadurch gekennzeichnet, daß die Oberfläche des Substrats aktiviert wird.

18. Vorrichtung zur Behandlung von Substratoberflächen mit einer Hohlkathode, bei dem ein Plasma mit einer Hohlkathoden-Glimmentladung in einer Vakuumkammer erzeugt wird, indem ein inertes Gas in Richtung auf das außerhalb der Hohlkathode angeordnete Substrat geführt ist und Reaktivgasdüsen (5) außerhalb der Hohlkathode angeordnet sind,
dadurch gekennzeichnet, daß mindestens ein Inertgasstrom (3) ein Eindringen von Reaktivgas in den von der Hohlkathode (2) vorgegebenen Entladungsbereich verhindernd, aus mindestens einer Inertgaszuführung (4) zuführbar ist und über der substratseitigen Öffnung der Hohlkathode (2) mindestens eine den offenen Querschnitt verengende Drosselstelle (20) angeordnet ist.

19. Vorrichtung zur Behandlung von Substratoberflächen mit einer Hohlkathode, bei dem ein Plasma mit einer Hohlkathoden-Glimmentladung in einer Vakuumkammer erzeugt wird, indem ein inertes Gas in Richtung auf das außerhalb der Hohlkathode angeordnete Substrat geführt ist und Reaktivgasdüsen (5) außerhalb der Hohlkathode angeordnet sind,
dadurch gekennzeichnet, daß zwischen einer Drosselstelle (20) und substratseitiger Öffnung der Hohlkathode eine Inertgaszuführung (21) angeordnet ist.

20. Vorrichtung zur Behandlung von Substratoberflächen mit einer Hohlkathode, bei dem ein Plasma mit einer Hohlkathoden-Glimmentladung in einer Vakuumkammer erzeugt wird, indem ein inertes Gas in Richtung auf das außerhalb der Hohlkathode angeordnete Substrat geführt ist und Reaktivgasdüsen (5) außerhalb der Hohlkathode angeordnet sind,
dadurch gekennzeichnet, daß mindestens ein Inertgasstrom (3) ein Eindringen von Reaktivgas in den von der Hohlkathode (2) vorgegebenen Entladungsbereich verhindernd, und die Hohlkathode (2) von einem die Hohlkathode (2) abschirmenden und/oder den Inertgasstrom führenden Gehäuse (13), umschlossen ist.

21. Vorrichtung nach mindestens einem der Ansprüche 18 bis 20,
dadurch gekennzeichnet, daß die Hohlkathode (2) sich einseitig aufweitend ausgebildet ist, wobei der aufgeweitete Teil in Richtung auf das Substrat (1) ausgerichtet ist.

22. Vorrichtung nach mindestens einem der Ansprüche 18 bis 21,
dadurch gekennzeichnet, daß mehrere Hohlkathoden (2) um eine zentrale Inertgaszuführung (4) zur gleichzeitigen Behandlung mehrerer Substrate (1) angeordnet sind.

23. Vorrichtung nach mindestestens einem der Ansprüche 18 bis 22,
dadurch gekennzeichnet, daß die Hohlkathode (2) aus parallel zueinander ausgerichteten Elementen gebildet und der Inertgastrom (3) in den Zwischenräumen geführt ist.

24. Vorrichtung nach Anspruch 23,
dadurch gekennzeichnet, daß die Elemente der Hohlkathode (2) rohrförmig zur Reaktivgaszuführung ausgebildet sind.

25. Vorrichtung nach mindestens einem der Ansprüche 18 bis 24,
dadurch gekennzeichnet, daß die Elemente der Hohlkathode (2) rohrförmig zur Kühlung ausgebildet sind.

26. Vorrichtung nach mindestens einem der Ansprüche 18 bis 25,
dadurch gekennzeichnet, daß die Hohlkathode (2) aus einer Platte (7) und mindestens einem dazu parallel ausgerichteten Netz (8) gebildet und der Inertgasstrom (3) durch die Netzmaschen in Richtung auf das Substrat (1) geführt ist.

27. Vorrichtung nach Anspruch 20,
dadurch gekennzeichnet, daß ein in seiner Form weitgehend dem Substrat (1) angepaßtes Gehäuse (10) dieses und ein weiteres gehäuseartiges Element (13) umschließt und Inertgas durch die Hohlkathoden bildende Durchbrechungen (13) auf das Substrat (1) gerichtet ist.

28. Vorrichtung nach mindestens einem der Ansprüche 18 bis 27,
dadurch gekennzeichnet, daß eine zusätzliche als Anode (11) geschaltete Elektrode in der Vakuumkammer angeordnet und mit einer Spannungsquelle verbunden ist.

## Claims

1. Method for the treatment of substrate surfaces with a hollow cathode, in which a plasma is generated with a hollow-cathode corona discharge in vacuo and is guided in the direction of the substrate, and a reactive gas stream is directed by flow or diffusion into the plasma present between the substrate-side end of the hollow cathode and the substrate,
characterized
in that the plasma is generated with an inert gas passed through the hollow cathode and, by a separate control of the inert gas plasma intensity, of the transport and of the ion bombardment of the substrate by means of the discharge power, of the gas flow and/or of a voltage applied to the substrate, these are set such that a reaction between reactive gas and cathode material is prevented to the greatest possible extent.

2. Method according to Claim 1,
characterized in that a working pressure of 0.1 to 10 mbar and a gas flow of 0.001 to 10 slm (standard litres per minute) are worked with.

3. Method according to Claim 1 or 2,
characterized in that a discharge voltage of 100 to 500 V is worked with.

4. Method according to at least one of Claims 1 to 3,
characterized in that a voltage is applied to the substrate of 10 to 800 V.

5. Method according to at least one of Claims 1 to 4,
characterized in that the flow rate of the inert gas plasma when leaving the hollow cathode is maintained or increased.

6. Method according to at least one of Claims 1 to 5,
characterized in that in order to suppress the reaction of reactive gas with the cathode material, additionally or exclusively at the substrate-side end inert gas is fed in and guided in the direction of the substrate.

7. Method according to at least one of Claims 1 to 6,
characterized in that the hollow-cathode corona discharge is generated by means of DC voltage.

8. Method according to at least one of Claims 1 to 7,
characterized in that the hollow-cathode corona discharge is generated by means of pulsed DC voltage.

9. Method according to at least one of Claims 1 to 6,
characterized in that the hollow-cathode corona discharge is generated by means of an AC voltage.

10. Method according to at least one of Claims 1 to 6,
characterized in that the hollow-cathode corona discharge is generated by means of a high voltage.

11. Method according to at least one of Claims 1 to 10,
characterized in that the propagation of the plasma to the substrate is intensified by a magnetic field.

12. Method according to at least one of Claims 1 to 11, characterized in that the hollow cathode is cooled.

13. Method according to at least one of Claims 1 to 12,
characterized in that argon is used as the inert gas.

14. Method according to at least one of Claims 1 to 13,
characterized in that silicon compounds, hydrocarbons, for example ethyne, H₂, O₂, N₂ or halogen-containing gases are used as the reactive gas.

15. Method according to one of Claims 1 to 14, characterized in that a layer is deposited on the substrate.

16. Method according to one of Claims 1 to 15, characterized in that substrate material is removed.

17. Method according to one of Claims 1 to 16, characterized in that the surface of the substrate is activated.

18. Apparatus for the treatment of substrate surfaces with a hollow cathode, in which a plasma is generated with a hollow-cathode corona discharge in a vacuum chamber by an inert gas being guided in the direction of the substrate, which is arranged outside the hollow cathode, and reactive gas nozzles (5) being arranged outside the hollow cathode,
characterized in that at least one inert gas stream (3), preventing ingress of reactive gas into the discharge region predetermined by the hollow cathode (2), can be fed in from at least one inert gas supply line (4), and at least one restriction point (20), which constricts the open cross section, is arranged above the substrate-side opening of the hollow cathode (2).

19. Apparatus for the treatment of substrate surfaces with a hollow cathode, in which a plasma is generated with a hollow-cathode corona discharge in a vacuum chamber by an inert gas being guided in the direction of the substrate, which is arranged outside the hollow cathode, and reactive gas nozzles (5) being arranged outside the hollow cathode,
characterized in that an inert gas supply line (21) is arranged between a restriction point (20) and the substrate-side opening of the hollow cathode.

20. Apparatus for the treatment of substrate surfaces with a hollow cathode, in which a plasma is generated with a hollow-cathode corona discharge in a vacuum chamber by an inert gas being guided in the direction of the substrate, which is arranged outside the hollow cathode, and reactive gas nozzles (5) being arranged outside the hollow cathode,
characterized in that at least one inert gas stream (3), preventing ingress of reactive gas into the discharge region predetermined by the hollow cathode (2), and the hollow cathode (2) are enclosed by a housing (13), which screens the hollow cathode (2) and/or guides the inert gas stream.

21. Apparatus according to at least one of Claims 18 to 20,
characterized in that the hollow cathode (2) is designed such that it widens at one end, the widened part being oriented in the direction of the substrate (1).

22. Apparatus according to at least one of Claims 18 to 21,
characterized in that a plurality of hollow cathodes (2) are arranged around a central inert gas supply line (4) for the simultaneous treatment of a plurality of substrates (1).

23. Apparatus according to at least one of Claims 18 to 22,
characterized in that the hollow cathode (2) is formed from elements oriented parallel to one another, and the inert gas stream (3) is guided in the interspaces.

24. Apparatus according to Claim 23,
characterized in that the elements of the hollow cathode (2) are constructed tubularly for the purpose of feeding in reactive gas.

25. Apparatus according to at least one of Claims 18 to 24,
characterized in that the elements of the hollow cathode (2) are constructed tubularly for the purpose of cooling.

26. Apparatus according to at least one of Claims 18 to 25,
characterized in that the hollow cathode (2) is formed from a plate (7) and at least one net (8) oriented parallel thereto, and the inert gas stream (3) is guided through the net meshes in the direction of the substrate (1).

27. Apparatus according to Claim 20,
characterized in that a housing (10) whose shape is largely matched to the substrate (1) encloses the latter and a further housing-like element (13), and inert gas is directed onto the substrate (1) through perforations (14) forming the hollow cathodes.

28. Apparatus according to at least one of Claims 18 to 27,
characterized in that an additional electrode connected as anode (11) is arranged in the vacuum chamber and connected to a voltage source.

## Revendications

1. Procédé pour traiter les surfaces de substrats avec une cathode creuse, selon lequel un plasma produit au moyen d'une effluve électrique de cathode creuse sous vide est guidé en direction du substrat, et un courant de gaz réactif est guidé par circulation ou diffusion dans le plasma présent entre l'extrémité, située côté substrat, de la cathode creuse et le substrat,
caractérisé en ce
que le plasma est produit par un gaz inerte traversant la cathode creuse et qu'au moyen d'une commande séparée de l'intensité du plasma du gaz inerte, du transport et du bombardement ionique du substrat au moyen de la puissance de décharge, du courant de gaz et/ou d'une tension appliquée au substrat, on règle ces caractéristiques de telle sorte qu'une réaction du gaz réactif et du matériau de la cathode est dans une large mesure empêchée.

2. Procédé selon la revendication 1, caractérisé en ce qu'on travaille avec une pression de travail comprise entre 0,1 et 10 mbars et un débit de gaz de 0,001 à 10 slm (litres standards par minute).

3. Procédé selon la revendication 1 ou 2, caractérisé en ce qu'on travaille avec une tension de décharge comprise entre 100 et 500 V.

4. Procédé selon au moins l'une des revendications 1 à 3, caractérisé en ce qu'une tension comprise entre 10 et 800 V est appliquée au substrat.

5. Procédé selon au moins l'une des revendications 1 à 4, caractérisé en ce que la vitesse de circulation du plasma de gaz inerte est maintenue ou accrue lorsque le plasma quitte la cathode creuse.

6. Procédé selon au moins l'une des revendications 1 à 5, caractérisé en ce que pour la suppression de la réaction du gaz réactif avec le matériau de la cathode, on introduit un gaz inerte en supplément ou exclusivement au niveau de l'extrémité située côté substrat et on le guide en direction du substrat.

7. Procédé selon au moins l'une des revendications 1 à 6, caractérisé en ce que l'effluve électrique dans la cathode creuse est produite avec une tension continue.

8. Procédé selon au moins l'une des revendications 1 à 7, caractérisé en ce que l'effluve électrique dans la cathode creuse est produite au moyen d'une tension continue pulsée.

9. Procédé selon au moins l'une des revendications 1 à 6, caractérisé en ce que l'effluve électrique dans la cathode creuse est produite avec une tension alternative.

10. Procédé selon au moins l'une des revendications 1 à 6, caractérisé en ce que l'effluve électrique de la cathode creuse est produite avec une haute tension.

11. Procédé selon au moins l'une des revendications 1 à 10, caractérisé en ce que la propagation du plasma en direction du substrat est intensifiée par un champ magnétique.

12. Procédé selon au moins l'une des revendications 1 à 11, caractérisé en ce que la cathode creuse est refroidie.

13. Procédé selon au moins l'une des revendications 1 à 12, caractérisé en ce qu'on utilise le gaz argon en tant que gaz inerte.

14. Procédé selon au moins l'une des revendications 1 à 13, caractérisé en ce qu'on utilise comme gaz réactif, des composés de silicium, des hydrocarbures, par exemple l'éthine, le H₂, le O₂, le N₂ ou des gaz contenant un halogène.

15. Procédé selon l'une des revendications 1 à 14, caractérisé en ce qu'on dépose une couche sur le substrat.

16. Procédé selon l'une des revendications 1 à 15, caractérisé en ce que du matériau du substrat est retiré.

17. Procédé selon l'une des revendications 1 à 16, caractérisé en ce que la surface du substrat est activée.

18. Dispositif pour traiter des surfaces de substrats avec une cathode creuse, dans lequel un plasma est produit au moyen d'une effluve électrique dans la cathode creuse dans une chambre à vide, alors qu'un gaz est introduit en direction du substrat disposé à l'extérieur de la cathode creuse et que des buses (5) de projection de gaz réactif sont disposées à l'extérieur de la cathode creuse, caractérisé en ce qu'au moins un courant de gaz inerte (3) peut être amené à partir au moins d'une alimentation de gaz inerte (4), tout en empêchant la pénétration du gaz réactif dans la zone de décharge prédéterminée par la cathode creuse (2), et qu'au moins un point d'étranglement (20), qui rétrécit la section transversale ouverte, est disposé au-dessus de l'ouverture, située côté substrat, de la cathode creuse (2).

19. Dispositif pour traiter des surfaces de substrats avec une cathode creuse, dans lequel un plasma est produit au moyen d'une effluve électrique dans la cathode creuse dans une chambre à vide, alors qu'un gaz est introduit en direction du substrat disposé à l'extérieur de la cathode creuse et que des buses (5) de projection de gaz réactif sont disposées à l'extérieur de la cathode creuse, caractérisé en ce qu'une alimentation de gaz inerte (21) est disposée entre un point d'étranglement (20) et une ouverture, située côté substrat, de la cathode creuse.

20. Dispositif pour traiter des surfaces de substrats avec une cathode creuse, dans lequel un plasma est produit au moyen d'une effluve électrique dans la cathode creuse dans une chambre à vide, alors qu'un gaz est introduit en direction du substrat disposé à l'extérieur de la cathode creuse et que des buses (5) de projection de gaz réactif sont disposées à l'extérieur de la cathode creuse, caractérisé en ce qu'au moins un courant de gaz inerte (3) est envoyé de manière à empêcher une pénétration du gaz actif dans la zone de décharge prédéterminée par la cathode creuse (2), et que la cathode creuse (2) est entourée par un boîtier (13) qui protège la cathode creuse (2) et/ou guide le courant de gaz inerte.

21. Dispositif selon au moins l'une des revendications 18 à 20, caractérisé en ce que la cathode creuse (2) est formée de manière à s'élargir d'un côté, la partie élargie s'étendant en direction du substrat (1).

22. Dispositif selon au moins l'une des revendications 18 à 21, caractérisé en ce que plusieurs cathodes creuses (2) sont disposées autour d'une alimentation centrale de gaz inerte (4) pour le traitement simultané de plusieurs substrats (1).

23. Dispositif selon au moins l'une des revendications 18 à 22, caractérisé en ce que la cathode creuse (20) est constituée d'éléments parallèles entre eux et que le courant de gaz inerte (3) est guidé dans les espaces intercalaires.

24. Dispositif selon la revendication 23, caractérisé en ce que les éléments de la cathode creuse (2) sont agencés avec une forme tubulaire pour le guidage du gaz réactif.

25. Dispositif selon au moins l'une des revendications 18 à 24, caractérisé en ce que les éléments de la cathode creuse (2) sont réalisés avec une forme tubulaire pour le refroidissement.

26. Dispositif selon au moins l'une des revendications 18 à 25, caractérisé en ce que la cathode creuse (2) est formée par une plaque (7) et par au moins un réseau (8) orienté parallèlement à cette plaque et que le courant de gaz intérieur (3) est guidé à travers les mailles du réseau en direction du substrat (1).

27. Dispositif selon la revendication 20, caractérisé en ce qu'un boîtier (10), dont la forme est dans une large mesure adaptée au substrat (1), entoure ce dernier et un autre élément en forme de boîtier (13), et que du gaz inerte est dirigé sur le substrat (1) à travers les perçages (13) formant les cathodes creuses.

28. Dispositif selon au moins l'une des revendications 18 à 27, caractérisé en ce qu'une électrode supplémentaire branchée en tant qu'anode (11) est disposée dans la chambre à vide et est reliée à une source de tension.
